# EUROPEAN PATENT APPLICATION

(11) **EP 2 469 253 A1**
(43) Date of publication of application: **27.06.2012**
(21) Application number: 10196981.4
(22) Date of filing: 24.12.2010
(51) Int. Cl.: G01J 3/44, G01N 21/65

(54) **System for electron microscopy and Raman spectroscopy**

(71) Applicant: HybriScan Technologies Holding BV, 7559 ND Hengelo (NL)
(72) Inventor: van Kollenburg-Crisan, Loretta, 6814 HW, Arnhem (NL); Otto, Cornelis, 7559 ND, Hengelo (NL)
(74) Representative: van Westenbrugge, Andries

(57) **Abstract**

Sample analysis system comprising an electron microscope (2), a Raman spectrometer (3), optionally an optical microscope (16) and a sample stage (4). The sample stage is aligned with an optical axis (5) of the electron microscope (2) in a first position and with an optical axis (6) of the Raman spectrometer (3) and optical microscope in a second position. The sample analysis system (1) further comprises a cryogenic installation (7) in thermal contact with the sample stage (4) for cooling at least a sample positioned on the sample stage (4) in operation.

## Description

### Field of the invention

The present invention relates to a system combining electron microscopy and Raman spectroscopy. In more detail, the present invention relates to a sample analysis system comprising an electron microscope, a Raman spectrometer, and a sample stage aligned with an optical axis of the electron microscope in a first position and with an optical axis of the Raman spectrometer in a second position.

### Prior art

International patent publication WO95/20242 discloses an electron microscope with Raman spectroscopy. An electron microscope is combined with an externally mounted Raman spectrometer. An optical guide is provided to guide light between the spectrometer and a specimen in the electron microscope. The specimen can be aligned with the longitudinal axis of the electron microscope or the Raman spectrometer light guide.

### Summary of the invention

The present invention seeks to provide an improved sample analysis system, allowing to analyze a broad spectrum of samples and adding an ability to correlate molecular distributions and morphology in samples that have otherwise a particular molecular mobility at other than cryogenic temperatures. This includes samples that are fluidic, gelatinous or suspensions at non-cryogenic temperature, such as food samples.

According to the present invention, a sample analysis system according to the preamble defined above is provided, wherein the sample analysis system further comprises a cryogenic installation in thermal contact with the sample stage for cooling at least a sample positioned on the sample stage in operation. This allows to analyze samples which at normal room temperature comprise fluid components, such as food samples. This analysis can be performed at the same or a different temperature with the electron microscope and Raman microscope (or Raman (micro-)spectrometer).

In a further embodiment, the sample analysis system further comprises an external cooling system having a supply line for transporting cooling medium to the cryogenic installation (e.g. a nitrogen gas based cooling system). These components can be easily and cost-effectively added to the other components of the sample analysis system. In a further embodiment, the supply line is a flexible line (also at cryogenic temperature). This allows movement of the sample stage, and the flexible line is e.g. a flexible tube of cold resistant (heat conducting) material, i.e. flexible at low temperature.

The sample analysis system comprises an internal cooling system in a further embodiment, which is in direct thermal contact with the cryogenic installation. E.g. a micro-cryogenic cooler may be positioned inside a vacuum chamber of the electron microscope, and an associated cold tip can be in contact with the sample stage, or the sample holder. This allows to minimize the footprint of the sample analysis system, and also makes installation more easy, as the existing vacuum chamber can be left intact.

The sample stage is made of a heat conducting material in a further embodiment, allowing to transfer heat away from the sample to cool the sample to cryogenic temperatures. The sample stage may be provided with a removable sample holder, allowing easy transport of multiple samples into the sample analysis system for analysis..

In a further embodiment, the sample stage is moveable in two dimensions allowing accurate alignment with the optical axis from either the electron microscope or the Raman spectrometer. Furthermore, the sample stage is moveable in three (orthogonal) dimensions in a further embodiment, allowing accurate focusing in addition.

The sample analysis system comprises a vacuum chamber in which the electron microscope and the sample stage are positioned, and a connection module providing a light beam path between the vacuum chamber and the Raman spectrometer. This allows easy addition of the Raman spectrometer to the system, ensuring a proper vacuum operation for the electron microscope.

In a further embodiment, the sample analysis system further comprises an optical microscope of which an optical axis in the sample analysis system coincides with the optical axis of the Raman spectrometer. The optical microscope may then be used to ensure proper operation and control of the Raman spectrometer part of the sample analysis system. The optical microscope image enables correlative comparisons with the electron microscope image and the Raman microscope image.

The sample analysis system further may comprise a scan control system in further embodiments for moving the sample stage in accordance with a scan pattern in the first position, and in accordance with the same scan pattern in the second position. This allows accurate repetition of a scan cycle for both types of analysis, increasing the reliability of the sample analysis system and enabling/increasing the possibilities for cross-correlate images from Raman microscopy, electron microscopy and optical microscopy.

The scan control system comprises a position detector for detecting the scan pattern, and a storage unit for storing the detected scan pattern in a further embodiment. The scan control system is further arranged to retrieve the detected scan pattern for scanning in the second position. The scan pattern may be a two dimensional scan pattern, or a three dimensional scan pattern, allowing to include a z-axis control. The z-axis control enables acquisition of depth resolved chemical information through Raman micro-spectroscopy and Raman microscopy, which improves abilities to interpret electron microscopy images of sample with an irregular surface or other three-dimensional information.

The electron microscope creates an image. The Raman microscope also creates an image. The images can be precisely correlated after a known displacement of the sample stage. Furthermore, a reflected light optical microscope has been added to facilitate sample inspection in general and inspection during cryogenic cycling and defrosting in particular. The optical microscope is reflective but may be replaced by a transmissive optical configuration. The optical microscope image also enables correlation between an electron microscope image and a Raman image, in this way expanding analytical properties of the microscope system.

It is understood that the Raman micro-spectrometer/microscope is designed as a confocal optical system, enabling acquisition of spatially resolved chemical information in three dimensions.

### Short description of drawings

The present invention will be discussed in more detail below, using a number of exemplary embodiments, with reference to the attached drawings, in which
Fig. 1 shows a schematic view of an embodiment of the sample analysis system according to the present invention;
Fig. 2 shows a schematic view of a further embodiment of the sample analysis system according to the present invention; and
Fig. 3 shows a more detailed view of a part of the embodiment of Fig. 2.

### Detailed description of exemplary embodiments

In the liquid state and gel-like state of materials, molecules are continuously diffusing and relocating. The motion or diffusion of molecules makes it difficult if not impossible to correlate exactly the molecular composition and distribution with structural or morphological features that reflect the nano-scale, meso-scale and macro-scale properties of typical samples. The known combination of an electron microscope and a Raman spectrometer is therefore not useable for such samples.

According to the present invention embodiments, an electron microscope and Raman spectrometer are combined with a cryogenic installation. These embodiments allow to perform analysis of samples relating to molecular analysis, molecular composition and molecular distribution in samples. Structural and morphological properties and chemical composition and distribution in samples are maintained, and correlation between structure and chemistry in samples can be established. This also applies for samples which are in a liquid to gel-like phase at other temperatures (e.g. at room temperature in a scanning electron microscope (SEM) in combination with a Raman spectrometer). Because of decreased molecular mobility and associated decrease in molecular damping effects, the present invention embodiments enable an improved, enhanced and more detailed molecular analysis using Raman spectroscopy and microscopy of samples.

The present invention embodiments can be applied in a wide range of applications, including but not limited to: vitrified/cryo-preserved or prepared liquids and/or gels, such as samples in food industry, chemical industry, oil industry, health, biology, etc. Samples can include tissues, cells, sperm cells, oocytes, medical tissues, biopts, plant cells, animal cells, synthetic tissues (tissue engineering), etc. In pharmaceutical applications, coating, filler and excipient identification can be performed, as well as quality control. For safety applications, nano-particle properties can be analyzed, as well as influence on cells. In life science applications (health and food), drugs can be analyzed, as well as drug distribution and activity in cells and tissues. Also cell differentiation, mineralization and cell characterization can be performed. The present invention embodiments also allow to serve as a generic tool for material science, such as for example corrosion studies, electronic materials, polymers, (painting) composites, laminated materials, semiconductors, etc.

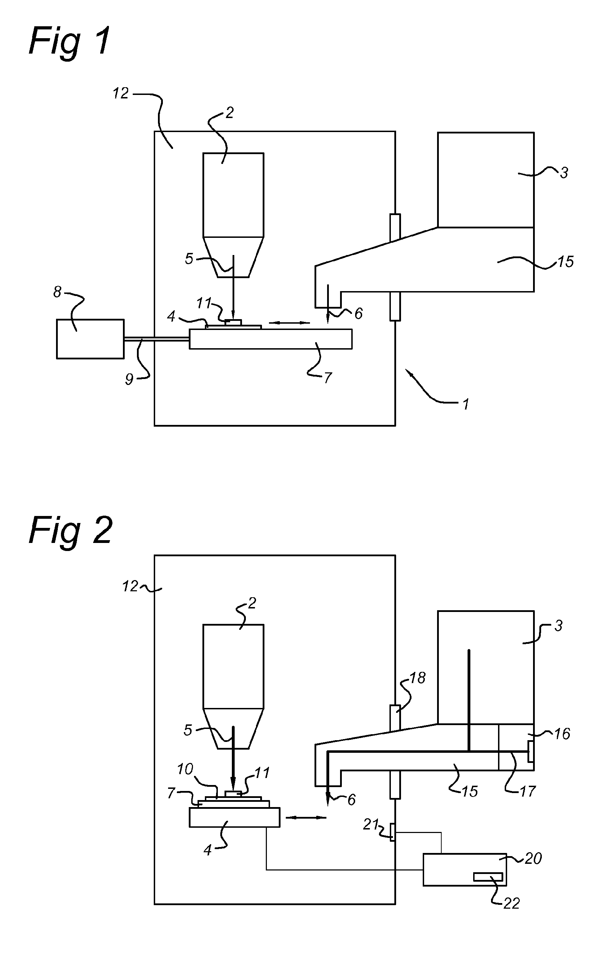

Fig. 1 shows a schematic view of an embodiment of a sample analysis system 1 according to the present invention. The sample analysis system 1 comprises a electron microscope 2 and a Raman spectrometer 3. A sample stage 4 is drawn in a first position here aligned with an optical axis 5 of the electron microscope 2, the sample stage 4 is however moveable towards a second position where it is aligned with an optical axis 6 of the Raman spectrometer 3.

At least the sample stage 4 and its environment are enclosed in a vacuum chamber 12 to allow electron microscopy of a sample held in a sample holder 11 on the sample stage 4. The sample holder 11 is in one embodiment a removable sample holder 11 which can be affixed to the sample stage 4 for analysis of samples contained therein. The removable sample holder 11 can be introduced in the vacuum chamber 12 using know techniques, e.g. using a load lock or a load door in the vacuum chamber 12 (allowing the vacuum chamber 12 to be evacuated when the sample is positioned).

In the embodiment shown in Fig. 1, the Raman spectrometer 3 is attached to the vacuum chamber 12 (in which the electron microscope 2 and sample stage 4 are positioned) using a connection module 15 providing a light beam path between the vacuum chamber 12 and the Raman spectrometer 3. The connection module 15 can be implemented as a closed element positioned inside the vacuum chamber 12.

The sample analysis system 1 is further provided with a cryogenic installation 7, 8, 9 in thermal contact with the sample stage 4. The cryogenic installation 7 allows to cool down the cryogenic stage 4, or at least a sample held in the sample holder 11 in operation. This allows to perform electron microscopy analysis of the sample, and after alignment with the optical axis 6 of the Raman spectrometer, also spectroscopic analysis of the same sample, even if the sample is a liquid or gel like material at room temperature.

To allow alignment with both the optical axis 5 of the electron microscope 2 and the optical axis 6 of the Raman spectrometer, the sample stage 4 is moveable in two dimensions in one embodiment. This allows the other elements in the vacuum chamber 12 (electron microscope 2 and connection module 15) to remain stationary, which leads to a robust, reliable and precise integration of electron microscope and Raman micro-spectrometer/microscope. As an alternative the sample stage 4 is stationary, and (elements of) the electron microscope 3 and the connection module 15 are moveable to allow alignment of the sample stage 4.

In a further embodiment, the sample stage 4 is moveable in three dimensions. This allows further refined alignment and/or focusing of the electron microscope and Raman spectrometer optics, to allow material analysis with the electron microscope and Raman micro-spectrometer/microscope of a sample, e.g. for three-dimensional chemical analysis e.g. in case of samples with an irregular surface.

The feature that the sample stage 4 can be positioned in different locations with respect to the electron microscope and Raman spectrometer optics can be implemented in various manners, which as such are known in electron microscope and other fields where a sample stage is moved. Examples of such implementations are disclosed in the international patent publication WO95/20242 discussed above, but also in the international patent publication WO03/014794. Furthermore, the sample stage 4 may be a sample stage already present in an off-the-shelf electron microscope, or it may be a sample stage specifically designed for this cryogenic EM-Raman system 1.

In an embodiment the sample stage 4 is made of heat conducting material, allowing cooling of the entire sample stage 4, a part thereof, or allowing cooling of the sample holder 11 using the cryogenic installation 7, 8, 9.

In the embodiment shown in Fig. 1, the sample analysis system 1 is provided with an external cooling system 8 having a supply line 9 for transporting cooling medium or as a heat-conducting connection to the cryogenic installation 7. The external cooling system 8 is e.g. based on a liquid nitrogen cooling system, a liquid helium cooling system or based on other technology to cool samples, e.g. by piezo-electric Peltier effect or the Joule-Thompson effect. The cooling system may be a closed circuit system allowing application in the vacuum chamber 12. The supply line 9 is a flexible line in a further embodiment, allowing movement of the supply line 9 in the vacuum chamber 12, e.g. when the sample stage 4 moves form the first to second position.

A further embodiment is shown in the schematic diagram of Fig. 2. In this embodiment, the sample analysis system 1 comprises an internal cooling system 10 in direct thermal contact with the cryogenic cooler 4. The internal cooling system 10 is positioned inside the vacuum chamber 12, which facilitates and eases cryogenic sample preparation and improves ease of assembly as only electrical power needs to be supplied to the internal cooling system 10. The internal cooling system 10 can e.g. be a micro-cryogenic cooler inside the vacuum chamber 12, the micro-cryogenic cooler being provided with a cold tip which is in direct thermal contact with the sample holder 11 (or the sample stage 4).

In the embodiment of Fig. 2, the sample analysis system 1 is further provided with an optical microscope 16. The optical microscope can be housed in the connection module 15 as indicated, or may form a separate attachable unit. An optical axis 17 of the optical microscope 16 coincides with the optical axis 6 of the Raman spectrometer 3 in the sample analysis system 1, to allow visual alignment of the sample holder 11 with the optical axis 6. This greatly handles the ease of use of the sample analysis system 1. The optical microscope enables correlative imaging between electron microscopy, Raman microscopy and optical microscopy. The optical microscope also provides a means of sample inspection, e.g. in the case of temperature cooling and temperature cycling of the sample, which further improves the reliability of operation and the fidelity of material analysis.

As indicated in the embodiment shown in Fig. 2, the sample analysis system 1 may further comprise a scan control system 20. The scan control system 20 may be used for positioning the sample table (and/or sample holder 11) using manual inputs (not shown). In a further embodiment, the scan control system 20 is used for moving the sample table 4 in accordance with a scan pattern in the first position, and in accordance with the same scan pattern in the second position, after translation of the sample table 4 from the first to the second position. This allows coupled and/or correlative analysis of the sample, both using electron microscopy and Raman spectroscopy.

The scan control system 20 receives input data from a position detector 21 and/or the electron microscope 5 and/or the optical microscope 15 for detecting and/or controlling the scan pattern (e.g. positioned inside the vacuum chamber 12). Furthermore, the scan control system 20 may comprise a storage unit 22 for storing the detected scan pattern, wherein the scan control system 20 is further arranged to retrieve the detected scan pattern for scanning in the second position. The position detector 21 may be any available position detector able to provide a specific accuracy requirement, such as a laser interferometer based position detector.

The scan pattern may be a two dimensional scan pattern, but for certain applications (e.g. irregular surface of the sample to be analyzed) the scan pattern is a three dimensional scan pattern, allowing movement in three, e.g. orthogonal, axes.

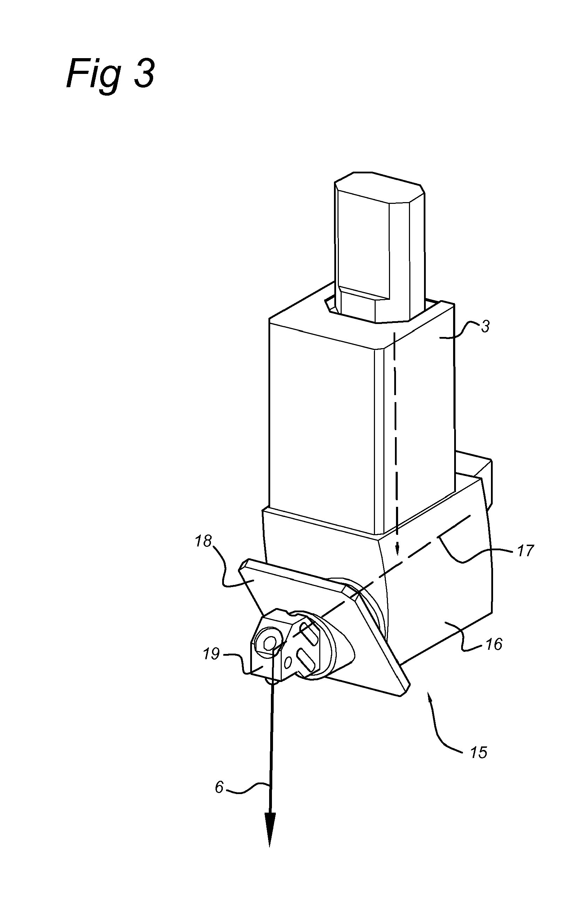

Fig. 3 shows a more detailed view of a part of the sample analysis system 1, more particularly of the Raman spectrometer 3 and optical microscope 16 attached to the connection unit 15. The Raman spectrometer 3 and optical microscope 16 are attached to each other and the optical paths of both are combined in the connection unit 15. The connection unit 15 comprises a flange 18 allowing attachment of the connection unit 15 to the vacuum chamber 12 of the electron microscope 2. A pick-up beam module 19 is part of the connection unit 15, and extends into the interior of the vacuum chamber 12. In Fig. 3 also the optical path ways of the Raman spectrometer (laser beam for incidence on the sample, and received back scatter light for analysis) and the optical microscope 16 are indicated in the Fig. 3. The optical microscope 16 may be provided with objective lenses for direct viewing of the sample, or with an image sensor and processing circuitry for providing images on a screen.

The sample analysis system according to the present invention embodiments enables and allows to combine chemical analysis using photons with analysis using electron microscopy. Virtually no additional foot print is required compared to a regular electron microscope, and existing electron microscopes can be equipped with embodiments with minimal adaptations. In further embodiments, the sample analysis system could be enhanced by using a combination with energy dispersive X-ray analysis or with photoluminescence spectroscopy.

The present invention embodiments have been described above with reference to a number of exemplary embodiments as shown in the drawings. Modifications and alternative implementations of some parts or elements are possible, and are included in the scope of protection as defined in the appended claims.

## Claims

1. Sample analysis system comprising
an electron microscope (2);
a Raman spectrometer (3); and
a sample stage (4) aligned with an optical axis (5) of the electron microscope (2) in a first position and with an optical axis (6) of the Raman spectrometer (3) in a second position,
wherein the sample analysis system (1) further comprises a cryogenic installation (7) in thermal contact with the sample stage (4) for cooling at least a sample positioned on the sample stage (4) in operation.

2. Sample analysis system according to claim 1, wherein the sample analysis system (1) further comprises an external cooling system (8) having a supply line (9) for transporting cooling medium to the cryogenic installation (7).

3. Sample analysis system according to claim 2, wherein the supply line (9) is a flexible line.

4. Sample analysis system according to claim 1, wherein the sample analysis system (1) comprises an internal cooling system (10) in direct thermal contact with the cryogenic installation (7).

5. Sample analysis system according to any one of claims 1-4, wherein the sample stage (4) is made of heat conducting material.

6. Sample analysis system according to any one of claims 1-5, wherein the sample stage (4) is provided with a removable sample holder (11).

7. Sample analysis system according to any one of claims 1-6, wherein the sample stage (4) is moveable in two dimensions.

8. Sample analysis system according to any one of claims 1-7, wherein the sample stage (4) is moveable in three dimensions.

9. Sample analysis system according to any one of claims 1-8, wherein the sample analysis system (1) comprises a vacuum chamber (12) in which the electron microscope (2) and the sample stage (4) are positioned, and a connection module (15) providing a light beam path between the vacuum chamber (12) and the Raman spectrometer (3).

10. Sample analysis system according to any one of claims 1-9, wherein the sample analysis system (1) further comprises an optical microscope (16) of which an optical axis (17) in the sample analysis system (1) coincides with the optical axis (6) of the Raman spectrometer (3).

11. Sample analysis system according to any one of claims 1-10, wherein the sample analysis system (1) further comprises a scan control system (20) for moving the sample stage (4) in accordance with a scan pattern in the first position, and in accordance with the same scan pattern in the second position.

12. Sample analysis system according to claim 11, wherein the scan control system (20) comprises a position detector (21) for detecting the scan pattern, and a storage unit (22) for storing the detected scan pattern, wherein the scan control system (20) is further arranged to retrieve the detected scan pattern for scanning in the second position.

13. Sample analysis system according to claim 11 or 12, wherein the scan pattern is a two dimensional scan pattern.

14. Sample analysis system according to claim 11 or 12, wherein the scan pattern is a three dimensional scan pattern.
